# FASCICULE DE BREVET EUROPEEN

(11) **EP 2 395 361 B1**
(45) Date de publication et mention de la délivrance du brevet: **21.09.2016**
(21) Numéro de dépôt: 11169444.4
(22) Date de dépôt: 10.06.2011
(51) Int. Cl.: G01R 13/34, H04B 1/00

(54) **Procédé de traitement de signaux RF/hyperfréquence analogiques reçus, de type très large bande, et récepteur mettant en oeuvre un tel procédé**
Verarbeitungsverfahren von empfangenen analogen RF/Hyperfrequenz-Signalen vom Typ Super-Breitband, und Empfänger zur Umsetzung dieses Verfahrens
Method for processing received analogue RF / hyperfrequency signals over a very wide frequency band, and receiver implementing such a method

(30) Priorité: 11.06.2010 FR 1002479
(43) Date de publication de la demande: 14.12.2011
(73) Titulaire: Thales, 92200 Neuilly Sur Seine (FR)
(72) Inventeur: Breuil, Nicolas, 91400 ORSAY (FR); Julie, Jean-Jacques, 94270 LE KREMLIN BICETRE (FR)
(74) Mandataire: Lucas, Laurent Jacques

(56) Documents cités:
- CA-A1- 2 281 238
- US-A- 5 706 203
- US-A- 5 714 878

## Description

L'invention porte sur les récepteurs dits à très large bande, c'est-à-dire aptes à fonctionner sur une bande de fréquence généralement comprise entre 20 et 30 GHz. Ces récepteurs peuvent être notamment incorporés dans des détecteurs d'alerte Radar ou des systèmes d'écoute ou des systèmes d'acquisition de type oscilloscope rapide. Ces récepteurs doivent travailler sur une large bande instantanée de fréquences et présenter une grande dynamique. On rappelle qu'une bande instantanée de fréquence est une « prise de vue » durant un court instant (par exemple moins de 1 ms) de la bande de fréquences analysée.

En sortie du récepteur, un moyen de calcul (par exemple un analyseur de spectre) effectue notamment une analyse du spectre électromagnétique du signal reçu. L'analyseur de spectre peut alors transférer les caractéristiques de fréquences, d'amplitudes, de largeurs d'impulsions, de périodes de répétition des impulsions et de modulations intra-pulse de l'ensemble des signaux reçus en provenance d'un ou plusieurs émetteurs situés dans l'environnement du récepteur.

Il existe deux approches d'analyse spectrale bande étroite ou large bande la principale différence entre ces deux approches concerne la bande passante instantanée qu'il est possible d'acquérir en temps réel.

Un analyseur de spectre bande étroite est un dispositif super hétérodyne qui permet d'obtenir une grande dynamique (c'est-à-dire un bon rapport entre le signal le plus faible et le signal le plus fort toléré, avant l'apparition des distorsions), au détriment de la bande instantanée et de la résolution fréquentielle.

A l'inverse, un analyseur de spectre large bande par exemple, propose une large bande instantanée mais au détriment de la dynamique.

Un récepteur dit à très large bande, par exemple incorporé dans un détecteur d'alerte Radar, emploie alternativement ou simultanément les deux méthodes pour enregistrer l'environnement électromagnétique. De ce fait, les détecteurs d'alerte Radar sont généralement des systèmes large bande qui permettent de réaliser une détection des fréquences et des amplitudes associées avec une grande sensibilité mais une faible dynamique instantanée. En outre la faible dynamique est souvent rendue nécessaire car ces détecteurs ne sont pas multi-signaux, mais opèrent impulsion par impulsion.

Des détecteurs d'alerte Radar plus perfectionnés appelés « ESM » par l'homme du métier (pour « Electronic Support Measure » en langue anglaise) se composent d'un système de transposition dit super hétérodyne permettant d'analyser une bande instantanée « réduite » autour d'une fréquence centrale choisie par l'opérateur. La bande instantanée doit être réduite pour deux raisons :
- la dynamique doit être la plus grande possible ; donc en réduisant la bande instantanée, le nombre de raies parasites diminue et la dynamique augmente,
- la vitesse des systèmes de conversion analogique/numérique incorporés dans ces récepteurs est limitée, on réduit donc la bande instantanée.

Le propre des récepteurs large bande par rapport aux appareils de mesure est d'analyser et de traiter en temps réel le flux de données incident pour donner en permanence à l'opérateur une situation actualisée.

Le système idéal serait un système compact qui permettrait d'allier une large bande avec une grande dynamique et si possible en codant directement sur la fréquence hyperfréquence.

Mais, les codeurs employés à ce jour ne permettent de traiter que 2 GHz de bande instantanée pour une dynamique compatible des besoins ESM autour d'une fréquence intermédiaire comprise ou inférieure à 4GHz. Il existe un type de codeur qui permet de travailler à des fréquences élevées et de réaliser le codage dans la première zone de Nyquist, en respectant le théorème de Shannon sur l'échantillonnage. En effet ce type de codeur permet d'échantillonner des signaux jusqu'à 28GHz en employant une fréquence horloge au moins égale à 56GHz. Ces codeurs échantillonnent directement sur porteuse, toutefois ils produisent une quantité de données qui n'est pas exploitable en flux direct. En effet le flux de données pour un codeur 8 bits est de 56GHz x 8 Bits c'est-à-dire 448Gbit/s. La montée en fréquence des codeurs comme la montée en fréquence des processeurs posent le problème des accès aux mémoires incorporées dans les codeurs.

Les processeurs actuels, implémentés dans les moyens de calcul précités, ne sont pas en mesure de traiter en temps réel des flux de données séries de 500Gbit/s.

Les récepteurs de l'état de la technique implémentent généralement des solutions reposant sur le demultiplexage des accès avec le passage d'un accès série unique haut débit à N accès parallèles (N=128 par exemple). En ce qui concerne un codeur, il est alors possible de réaliser une sortie démultiplexée à une fréquence plus faible. Par exemple pour un codeur 50Gbps avec 128 voies de sortie la fréquence horloge en sortie sera de 390MHz. Une approche classique consisterait à placer N enregistreurs pour traiter les N voies simultanément, mais la vitesse d'enregistrement des mémoires est incompatible avec un enregistrement en flux réel et donc une réponse en temps réel pour une application à un système de détection d'alerte par exemple. De plus il n'est pas possible de sortir physiquement de la puce compte tenu de la dissipation thermique occasionnée par chacune des 128 sorties.

Un document CA 2 281 238 A1 décrit une commande automatique de gain pour récepteurs numériques d'interception radar. Un document US 5 707 203 A décrit un dispositif de mesures de formes d'onde. Un document US 5 714 878 A décrit un procédé de mémorisation de formes d'ondes.

L'invention cherche notamment à résoudre les problèmes énoncés ci-dessus, plus particulièrement à proposer un récepteur de type très large bande apte à traiter un grand nombre de données liées au fonctionnement sur une très large bande de fréquence tout en conservant un bonne dynamique et une bande de fréquence instantanée relativement importante.

L'invention a également pour but de proposer un récepteur permettant une analyse spectrale du signal reçu en temps réel.

A cet effet, selon un premier aspect, il est proposé un procédé de traitement de signaux RF/hyperfréquence analogiques reçus, de type très large bande, par un récepteur formé de 2n modules couplés en parallèle, n étant un entier non nul, chaque module comportant 2p codeurs de type haut-débit, p étant un entier non nul, chacun des codeurs incorporant une mémoire.

Selon une caractéristique générale de ce premier aspect, ledit procédé comprend pour chaque module :
- un échantillonnage des signaux RF/hyperfréquence analogiques reçus en fonction d'une fréquence d'échantillonnage choisie selon le théorème de Shannon sur l'échantillonnage, de façon à obtenir des échantillons de données numériques représentatifs desdits signaux analogiques,
- 2p phases d'écriture simultanées des mêmes échantillons de données numériques sur les mémoires des 2p codeurs qu'il incorpore, puis
- 2p phases de lecture simultanées de ces échantillons de données,
de façon que dès qu'un module est en phase de lecture, un autre module est parallèlement en phase d'écriture.

En d'autres termes, l'invention propose de paralléliser les phases de lecture et d'écriture des mémoires selon qu'elle appartient à un module ou un autre. Cela permet de s'affranchir des temps d'accès et d'écriture des mémoires, et par conséquent de traiter une grande quantité de données.
- Par ailleurs l'augmentation de la bande instantanée des récepteurs imposent des codeurs de type haut-débit dont l'utilisation est limité par les temps de transfert entre codeur et ressources de calcul. Leur utilisation est possible du fait de la mise en parallèle des phases de lecture et d'écriture sur les mémoires.

En outre, en choisissant correctement la fréquence d'échantillonnage (en fonction du théorème de Shannon sur l'échantillonnage, bien connu de l'homme du métier), il est alors possible d'augmenter la bande de fréquence instantanée.

Selon un mode de mise en oeuvre, pour chaque module, une phase de lecture de la mémoire du i^{ème} codeur comprend de préférence la lecture du j^{ème} 2p^{ième} des échantillons de données numériques stockées par ladite mémoire, i étant un entier variant entre k et k+2p-1 avec k=1, 2, 3 ou 4 la valeur de i pouvant être de 128 x 128 = 16kmots.

La lecture par partie de chaque mémoire (par exemple par quart successif, si un module comprend quatre codeurs k=4) permet d'effectuer un traitement ultérieur en parallèle sur chaque partie lue, et ainsi de l'effectuer en temps réel.

Selon un mode de mise en oeuvre, chaque mémoire est organisée selon une matrice structurée en lignes et colonnes, et dans lequel chaque phase de lecture d'une mémoire peut être effectuée suivant les colonnes, et où seuls les échantillons de données d'une colonne sur d sont lus, d étant un entier non nul.

Par exemple, il vient d=128.

Selon un autre mode de mise en oeuvre, chaque mémoire est organisée selon une matrice structurée en lignes et colonnes, est dans lequel chaque phase de lecture d'une mémoire peut être effectuée suivant les colonnes, où pour chaque colonne, seul un échantillon sur e est lu, e étant un entier non nul.

Par exemple, il vient e=32.

Ces différentes possibilités d'effectuer la phase de lecture au sein de chaque mémoire, permet une lecture plus ou moins rapide, selon le degré de résolution demandé par l'application concernée.

Selon un mode de mise en oeuvre, le procédé de traitement peut comprendre en outre 2p phases de calcul respectivement effectuées par au moins 2p sous-moyens de calcul, suite à chaque phase de lecture de données au sein des mémoires, chaque phase de calcul étant opérée sur les données issues de la phase de lecture, de façon que la phase de calcul soit effectuée en temps réel.

Selon un autre mode de mise en oeuvre, les 2p phases de calcul peuvent être effectuées alternativement par 2p sous-moyens de calcul et 2p autres sous-moyens de calcul, de façon que la phase de calcul soit effectuée en temps réel.

Selon un deuxième aspect, il est proposé un récepteur comprenant une antenne de réception apte à recevoir des signaux RF/hyperfréquence analogiques, destinés à être traiter par ledit récepteur.

Selon une caractéristique générale de ce deuxième aspect, le récepteur comprend :
- 2n modules de réception couplés en parallèle entre l'antenne et le moyen de calcul, n étant un entier supérieur ou égal à un, chaque module comprenant 2p moyens de conversion analogique/numérique aptes à convertir les signaux RF/hyperfréquence analogiques en échantillons de données numériques en fonction d'une fréquence d'échantillonnage choisie selon le théorème de Shannon sur l'échantillonnage, p étant un entier supérieur ou égal à un, 2p codeurs de type haut-débit montés en parallèle, respectivement couplés au 2p convertisseurs analogiques/numériques, chaque codeur incorporant une mémoire, les 2p mémoires étant aptes à stocker les même échantillons de données, et
- un moyen de distribution apte à distribuer le signal électromagnétique vers chaque convertisseur analogique/numérique de chaque module.

Selon un mode de réalisation, le moyen de calcul peut incorporer 2p sous-moyens de calcul, chaque codeur étant couplé en sortie respectivement à l'un des sous-moyens.

Selon un autre mode de réalisation, le moyen de calcul peut incorporer 4p sous-moyens de calcul, chaque codeur étant couplé en sortie à respectivement deux sous-moyens de calcul, en parallèle.

D'autres avantages et caractéristiques de l'invention apparaîtront à l'examen de la description détaillée de modes de réalisation et de mise en oeuvre de l'invention, nullement limitatifs, et des dessins annexés sur lesquels :
- la figure 1 illustre de façon simplifiée un récepteur selon l'invention,
- la figure 2 illustre un mode de réalisation d'un récepteur selon l'invention,
- la figure 3 illustre un autre mode de réalisation d'un récepteur selon l'invention,

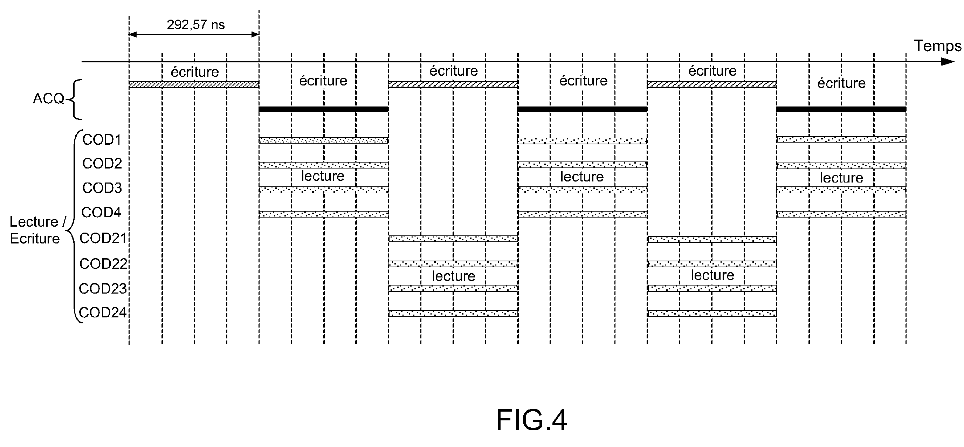

- la figure 4 illustre un mode de mise en oeuvre d'un procédé selon l'invention,
- les figures 5 et 6 illustrent deux façons de lire une mémoire incorporée dans un codeur d'un récepteur selon l'invention,
- la figure 7 illustre un autre mode de réalisation d'un récepteur selon l'invention,
- la figure 8 illustre un mode de mise en oeuvre d'un procédé selon l'invention, associé au mode de réalisation représenté sur la figure 5,
- la figure 9 illustre un autre mode de réalisation d'un récepteur selon l'invention,
- la figure 10 illustre un mode de mise en oeuvre d'un procédé selon l'invention, associé au mode de réalisation représenté sur la figure 7,
- selon l'invention.

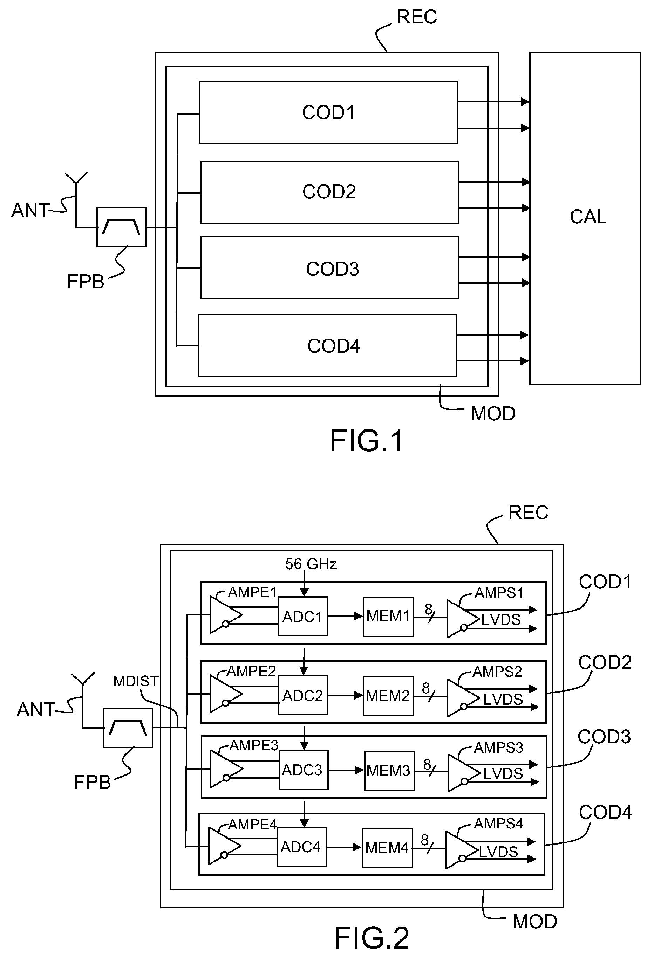

On se réfère à la figure 1. La référence REC désigne un récepteur, par exemple incorporé au sein d'un détecteur d'alerte Radar.

Ce récepteur REC est couplé à une antenne ANT via un filtre passe-bande FPB. Cette antenne ANT est apte à capter des signaux sur une très large bande de fréquence, typiquement entre 2 et 20GHz ou 30GHz.

De façon à simplifier la description, le récepteur REC n'incorpore dans cet exemple de la figure 1 qu'un seul module MOD. Ce module MOD comprend ici quatre codeurs COD1, ..., COD4 couplés en parallèle. Ils sont reliés au filtre passe-bande FPB par un moyen de distribution MDIST.

Plus généralement, un module MOD peut comprendre 2p codeurs, p étant un entier non nul. Sur la figure 1 et dans la suite de la description, p=2, mais cet exemple n'est pas du tout limitatif. La valeur choisie est notamment liée à l'application considérée.

La sortie de chaque codeur COD1, ..., COD4 se fait par voie différentielle. Elle connecte chaque codeur COD1, ..., COD4 à un moyen de calcul CAL, décrit plus en détail ci-après.

Les codeurs COD1, ..., COD4 sont des codeurs synchrones à haut débit ou codeurs rapides. Ces derniers sont décrits plus en détail sur la figure 2.

Chaque codeur COD1, ..., COD4 comprend un amplificateur d'entrée AMPE1, ..., AMPE4 apte à amplifier les signaux RF/hyperfréquence analogiques reçus, dont l'amplitude a été atténuée par le moyen de distribution MDIST.

En sortie de chaque amplificateur d'entrée AMPE1, ..., AMPE4 est connecté un moyen de conversion analogique/numérique ADC1, ..., ADC4 apte à échantillonner le signal reçu. La fréquence d'échantillonnage est dans cet exemple de 56 GHz. Cette dernière est choisie de façon à respecter le théorème de Shannon sur l'échantillonnage bien connu de l'homme du métier.

Chaque codeur à haut débit incorpore une mémoire MEM1, ..., MEM4 de façon a y enregistrer temporairement les données numériques issues des moyens de conversion analogique/numérique ADC1, ..., ADC4 auxquels sont respectivement couplées les mémoires MEM1, ..., MEM4.

Les sorties des mémoires MEM1, ..., MEM4 sont respectivement connectées à un amplificateur de sortie AMPS1, ..., AMPS4 auxquels elles délivrent des données codées sur 8 bits. Les amplificateurs de sortie AMPS1, ..., AMPS4 délivrent en différentiel des données ici de type LVDS (« Low Voltage Differential Signal » en langue anglaise) vers le moyen de calcul CAL.

Dans l'exemple considéré, chaque mémoire MEM1, ..., MEM4 a un temps d'accès qui est donné par le débit maximum et par sa taille. Pour une mémoire ayant 128 accès et de profondeur 128 échantillons (correspondant à une matrice 128*128), le temps d'écriture sera de 327ns. Le temps d'accès en lecture étant également limité à 328ns pour 128 échantillons à 390MHz.

On note que pour ces mémoires, il n'est pas possible de venir enregistrer et lire simultanément les informations. L'art antérieur propose donc d'écrire les informations dans les mémoires pendant une demi-période puis de les lire pendant une autre demi-période. Ce principe n'est pas compatible avec les applications de détection d'alerte Radar par exemple, puisque le système devient « aveugle » pendant la demi-période de lecture des données dans les mémoires. En outre, les impulsions à détecter pouvant être très courtes, il est possible de ne pas en détecter une grande quantité pendant la phase de lecture au sein des mémoires.

A l'inverse, l'invention propose une mise en parallèle des phases de lecture et des phases d'écriture au sein de ces mémoires.

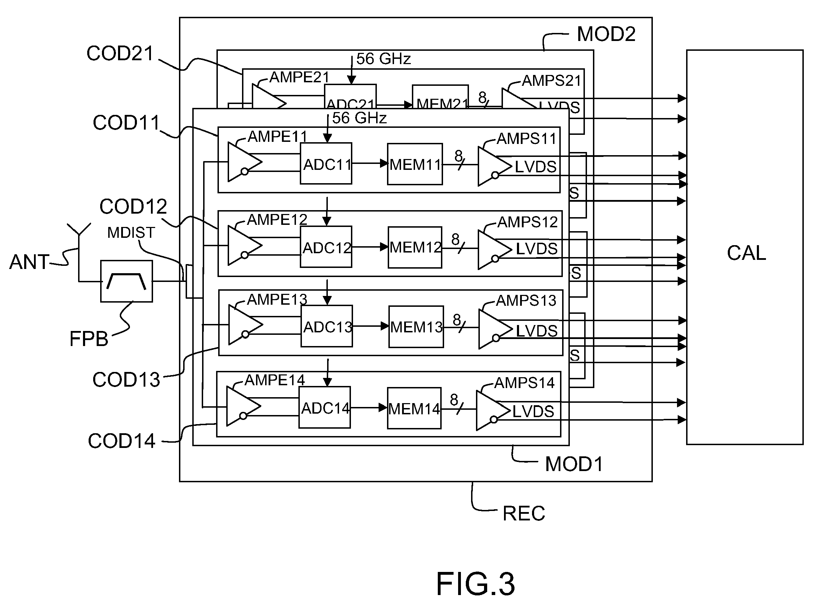

La figure 3 représente un mode de réalisation d'un récepteur selon l'invention. En effet, le récepteur REC incorpore 2n modules, n étant un entier non nul. Dans cet exemple et dans la suite de la description (sauf indication contraire), n est égal à 1. Le récepteur REC comprend donc ici deux modules MOD1 et MOD2 identiques dans leur architecture.

Le mode de mise en oeuvre des phases de lecture entre les codeurs des différents modules, ici deux modules référencés MOD1 et MOD2.

La référence ACQ représente les différentes phases d'acquisition de signaux par l'antenne.

Comme représenté sur le chronogramme, lorsque les mémoires des codeurs COD11, ..., COD14 du premier module MOD1 sont en phase de lecture, les mémoires des codeurs COD21, ..., COD24 du deuxième module MOD2 sont en phase d'écriture.

Ainsi, à chaque acquisition du signal, il existe un ensemble de mémoires disponibles pour écrire les données acquises.

A chaque phase d'écriture, les mêmes données sont écrites sur les mémoires des codeurs d'un même module. Cette redondance est exploitée lors de la phase de calcul effectuée par le moyen de calcul comme expliqué ci-après.

Pour un module donné, à chaque phase de lecture, seul le premier quart des données stockées dans la mémoire du premier codeur est lu. Simultanément, le deuxième quart des données stockées dans la mémoire du deuxième codeur est lu, ainsi que le troisième quart des données stockées dans la mémoire du troisième codeur et le quatrième quart des données stockées dans la mémoire du quatrième codeur.

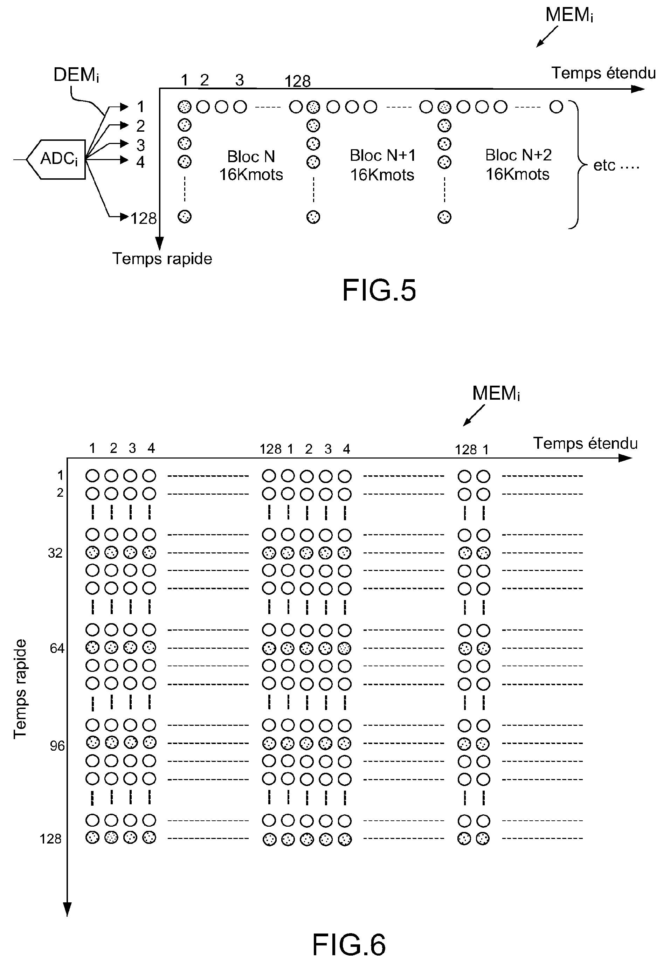

La figure 5 représente un exemple de mémoire organisée ici en matrice de 128*128. Bien entendu, ce choix de dimension n'est pas du tout limitatif. La dimension de la mémoire est ajustable en fonction de l'application considérée.

Le convertisseur analogique/numérique ADCi est réalisé à l'aide d'un composant effectuant une fonction d'échantillonnage rapide égale à au moins deux fois la fréquence la plus haute du signal à analyser ( théorème de Shannon sur l'échantillonnage). Le codage de chaque échantillon se fait sur M bits, avec M > 4, typiquement 8 bits (ce qui est le cas ici).

Le convertisseur analogique/numérique ADCi qui de fait échantillonne le signal RF/hyperfréquence analogiques reçu, est suivi par un démultiplexeur DEMi qui permet de distribuer 128 échantillons vers 128 voies spatiales. Les 128 mots de 8 bits sont enregistrés dans un ou des mémoires. A titre indicatif, on précise que cet enregistrement est appelé « temps rapide » car il se fait à un taux d'échantillonnage équivalent à la fréquence horloge du codeur (non représentée sur les figures à des fins de simplification).

L'autre axe est appelé « temps étendu ». Il entre en jeu lors de la lecture des données dans la mémoire.

Chaque phase de lecture correspond à la lecture d'un quart des données stockées dans la mémoire considérée, en fonction du rang de la mémoire au sein du codeur considéré. En outre, de façon à diminuer le temps de lecture des données, il est possible de ne lire les échantillons stockés que dans une partie des colonnes, dans cet exemple 1 colonne sur 128, comme expliqué ci-avant. Cette façon de procéder constitue un excellent compromis entre un temps de lecture relativement court, et une précision satisfaisante des résultats délivrés par le moyen de calcul.

En effet, dans l'exemple considéré ici, on rappelle que la fréquence d'échantillonnage choisie pour le convertisseur analogique/numérique est de 56GHz.

La période d'échantillonnage (axe « temps rapide ») est de 0,01786 ns. Le codage de 128 X 128 échantillons = 16384 échantillons se fait donc en un temps de 292,57143 ns.

Le temps de lecture devrait alors être de 292,574143ns. Pour observer des impulsions d'une largeur d'impulsion minimale de 50 ns, il faut observer 128 échantillons pris dans l'axe temps rapide, toutes les 292,57143 ns / 6 colonnes lues = 48,762 ns donc a priori, il faut effectuer 6 lectures à chaque acquisition.

L'important est de mettre en correspondance proprement les mesures d'une acquisition sur l'autre. Pour ce faire il faut prendre un sous-multiple de 128 (axe « temps étendu ») soit par exemple: 16, 32, 48, 64, 80, 96, 112, 128. Cela fait huit mesures, ce qui donne une résolution supérieure à 35,42 ns.

Dans cet exemple, on part avec quatre mesures pour chaque acquisition (par exemple : 16, 48, 80, 112). La zone aveugle est de 70,85ns ((16384-4x128) / (56 * 4)). Cela donne une résolution temporelle meilleure que 70,85 ns en valeur instantanée. Comme les impulsions glissent temporellement par rapport aux mesures, la réalisation d'une moyenne permettra d'améliorer la précision de mesure sur la largeur d'impulsion.

Pour réaliser cette opération, quatre codeurs sont utilisés travaillant rigoureusement en parallèle, comme illustré sur la figure 2. Il est possible d'en utiliser huit pour une meilleure résolution temporelle.

Comme indiqué ci-avant, les mémoires sont écrites séquentiellement, par bloc de 4, avec les mêmes données échantillonnées mais peuvent être lues par paquets de 128 avec une adresse de départ variable pour chaque codeur (cas 16 : @ de 2048 à 2178 ; cas 48 : @ 6144 à 6272, etc ...). Cette adresse est un paramètre de configuration fourni par un organe externe par exemple un PC, non représenté à des fins de simplification.

La figure 6 illustre une autre façon de lire les mémoires des codeurs.

Il est en effet possible de lire la mémoire selon « l'axe rapide » avec un écart entre les échantillons de 32. Au final, sont lus 128 points x 32 échantillons = 4096 échantillons, soit 1/4 de la mémoire.

Selon cet exemple, avec quatre codeurs montés en parallèle, 128 échantillons sont délivrés toutes les 73,143 ns. Ce qui donne un débit de 571,53 Moctets / s (chaque échantillon est codé sur 1 octet).

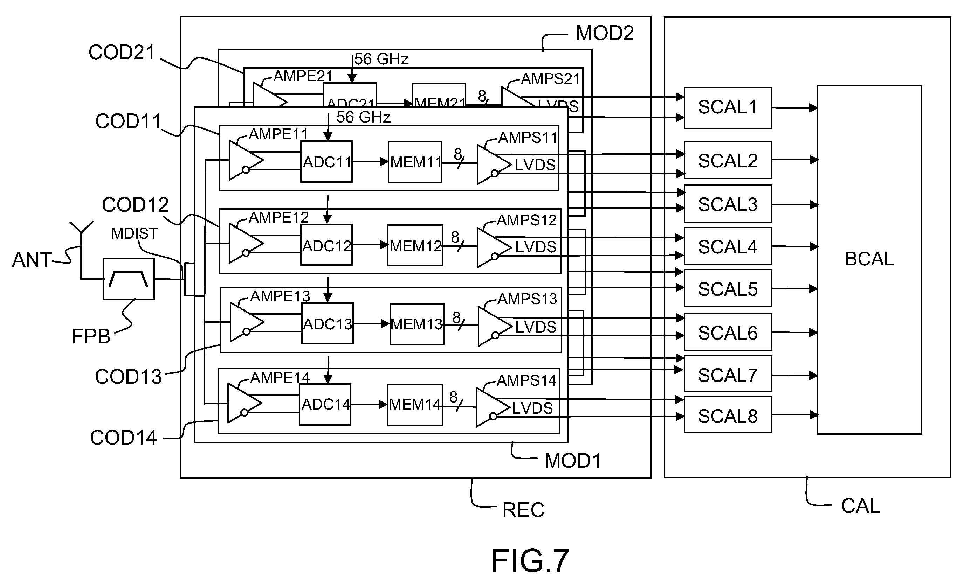

On se réfère à présent à la figure 7 qui illustre plus précisément le moyen de calcul CAL.

Le mode de réalisation du récepteur REC est identique à celui de la figure 3.

Celui-ci comprend huit sous-moyens de calcul SCAL1, ..., SCAL8, chacun étant respectivement connecté à la sortie de l'un des codeurs COD11, ..., COD14, COD21, ..., COD24 des deux modules MOD1 et MOD2.

Chaque sous-moyen de calcul SCAL1, ..., SCAL8 est apte à traiter les données délivrées par le codeur auquel il est couplé, c'est-à-dire seulement un quart des données stockées dans la mémoire correspondante.

Par conséquent, chaque sous-moyen de calcul a une quantité limitée de données à traiter, compatible avec un traitement en temps réel. Par exemple, chaque sous-moyen de calcul peut mettre en oeuvre un algorithme de Goertzel, qui est une variante de la Transformée de Fourier. Il présente l'avantage de pouvoir choisir des fréquences d'observation à un pas variable qui n'est pas 2^{N}. Cet algorithme est décrit par exemple à la page 287 du manuel « *Digital Signal Processing* » par A. V. Oppenhein & RW Schafer, Prentice Hall.

Les sous-moyens de calcul peuvent être des FPGAs (« Field-Programmable Gate Array », en langue anglaise) ou des ASICs (« Application Specific Integrated Circuit » en langue anglaise).

Puis un bloc de calcul BCAL, une fois le débit réduit, réalise des opérations sur l'ensemble des données traitées et délivrées par les sous-moyens de calcul SCAL1, ..., SCAL8.

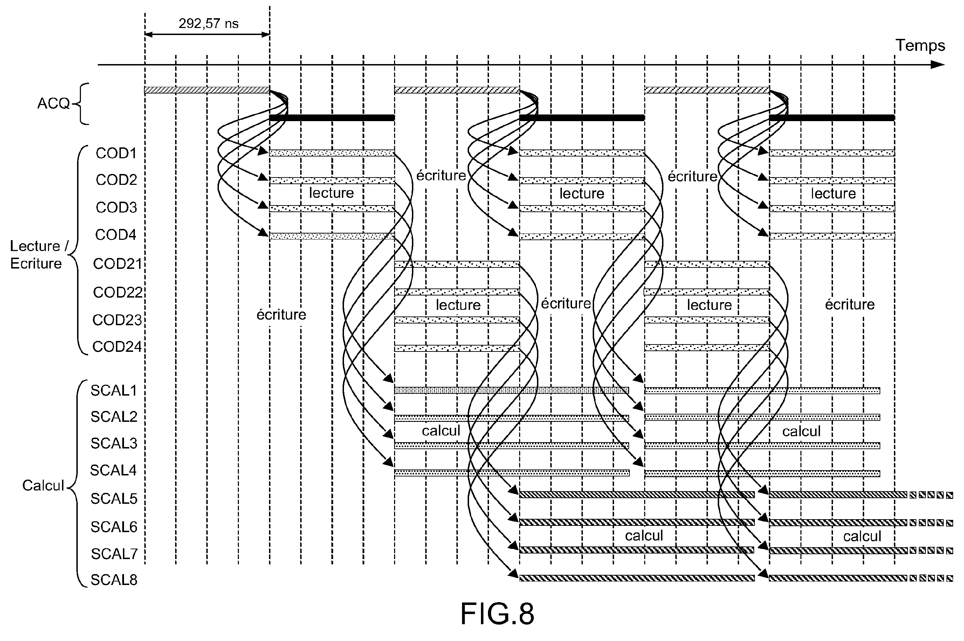

La figure 8 représente un chronogramme où se trouve outre les phases d'écriture et de lecture sont représenter les phases de calcul.

Après chaque phase de lecture réalisée sur les mémoires des codeurs d'un même module, est réalisée une phase de calcul sur les données lues par le sous-moyen de calcul correspondant.

Du fait de la mise en parallèle des phases de lecture et d'écriture associées aux deux modules, il existe également une mise en parallèle des phases de calcul. Ainsi, chaque sous-moyen de calcul peut traiter les données lues pendant deux temps d'acquisition des signaux par l'antenne.

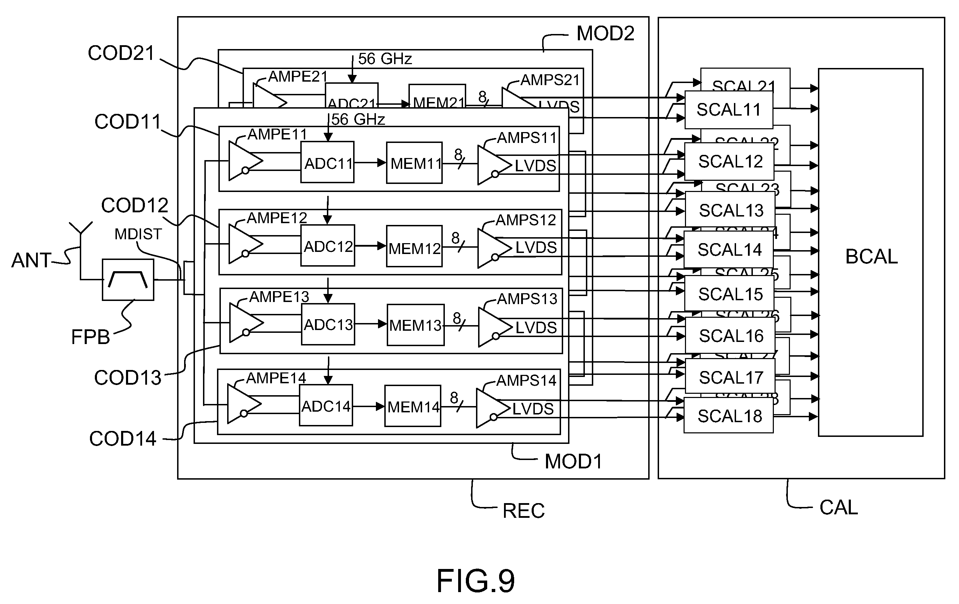

La figure 9 illustre un autre mode de réalisation du moyen de calcul CAL.

Dans ce mode de réalisation, deux sous-moyens de calcul SCAL11, SCAL12, ..., SCAL81, SCAL82 sont respectivement couplés en parallèle à la sortie de chaque codeur COD11, ..., COD14, COD21, ..., COD24.

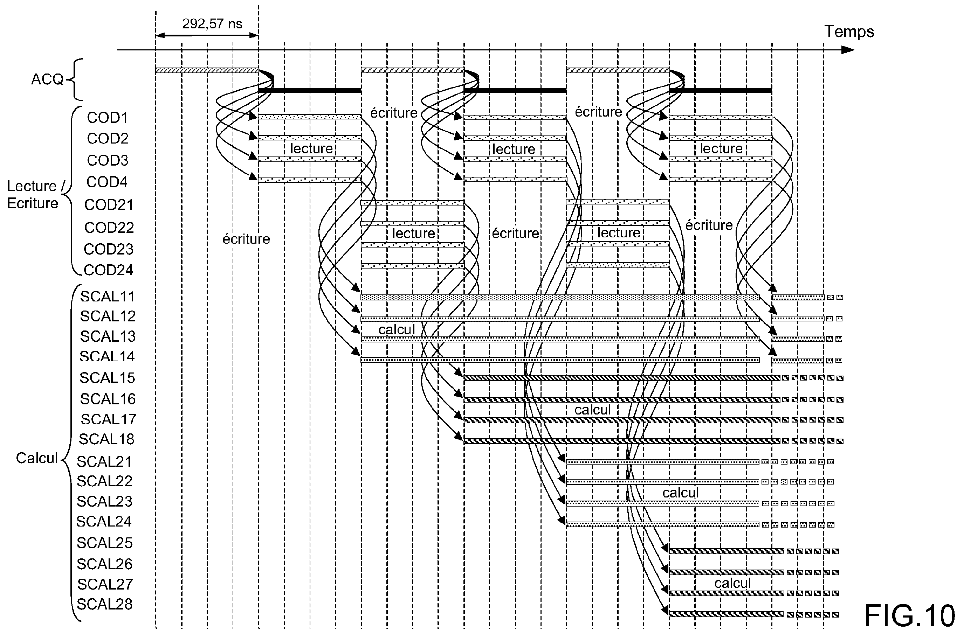

Comme représenté sur le chronogramme de la figure 10, pour les codeurs d'un même module, les données lues vont être alternativement traitées par l'un ou l'autre sous-moyen de calcul couplé en sortie du codeur considéré. Cela permet d'allonger à quatre temps d'acquisition la phase de calcul pour les données lues au cours d'une phase de lecture.

A titre indicatif, il est indiqué qu'un récepteur selon l'invention a entre autre pour avantage :
- de n'avoir aucun étage de transposition hyperfréquence analogique, impliquant un gain de fiabilité, de performances, reproductibilité des systèmes en production série et de coût ;
- une compacité compatible avec une intégration dans des blocs antennes unitaires et modulaires ;
- une possibilité de connexion à un réseau numérique de type intranet, et donc un gain sur les coûts ;
- un gain en coût de fabrication et d'implantation (car la partie analogique est réduite entre l'antenne et les convertisseurs analogique/numérique) ;
- un traitement en temps réel d'une large bande de signal de plusieurs dizaines de gigahertz à l'aide d'un récepteur autonome ;
- un accès à une dynamique instantanée équivalente aux systèmes actuels et supérieure à 6 bits ;
- une grande précision de fréquence en un temps de traitement optimal, grâce à une redondance intégrée au sein du récepteur et de fait une amélioration de la probabilité d'interception fréquentielle et temporelle ; et
- un traitement en temps réel qui réduit le flux de données, ce qui limite les besoins de stockage.

Avantageusement, le temps rapide permet d'obtenir une portion de signal de 128 points consécutif selon la colonne i échantillonnée à la fréquence rapide. Par ailleurs, la matrice complète « temps rapide - temps étendu » permet de mettre en oeuvre des techniques de sous-échantillonnage avec une lecture de 1 point par paquet de 32 par exemple. Cette seconde approche donne accès à une acquisition sur l'axe « temps étendu », ce qui permet d'accéder à une résolution plus fine à la fois en temps et en fréquence.

## Revendications

1. Procédé de traitement de signaux électromagnétiques reçus, de type très large bande, par un récepteur (REC) formé de 2n modules (MOD1, MOD2) couplés en parallèle, n étant un entier non nul, chaque module comportant 2p codeurs (COD1, ..., COD4) de type haut-débit, p étant un entier non nul, chacun des codeurs incorporant une mémoire (MEM1, ..., MEM4),
**caractérisé par le fait que** ledit procédé comprend pour chaque module :
- un échantillonnage des signaux RF/hyperfréquence analogiques reçus en fonction d'une fréquence d'échantillonnage choisie selon le théorème de Shannon sur l'échantillonnage, de façon à obtenir des échantillons de données numériques représentatifs desdits signaux RF/hyperfréquence analogiques,
- 2p phases d'écriture (écriture) simultanées des mêmes échantillons de données numériques sur les mémoires des 2p codeurs qu'il incorpore, puis
- 2p phases de lecture (lecture) simultanées de ces échantillons de données,
de façon que dès qu'un module est en phase de lecture, un autre module est parallèlement en phase d'écriture.

2. Procédé de traitement selon la revendication précédente, dans lequel pour chaque module (MOD1, MOD2), une phase de lecture de la mémoire du i^{ème} codeur comprend la lecture du k et k+2p-1 avec k=1, 2, 3 ou 4 des échantillons de données numériques stockées par ladite mémoire, i étant un entier variant entre 1 et 2p.

3. Procédé de traitement selon la revendication précédente, dans lequel chaque mémoire est organisée selon une matrice structurée en lignes et colonnes, est dans lequel chaque phase de lecture d'une mémoire est effectuée suivant les colonnes, et où seuls les échantillons de données d'une colonne sur d sont lus, d étant un entier non nul.

4. Procédé de traitement selon la revendication précédente, dans lequel d=128.

5. Procédé de traitement selon la revendication 2, dans lequel chaque mémoire est organisée selon une matrice structurée en lignes et colonnes, est dans lequel chaque phase de lecture d'une mémoire est effectuée suivant les colonnes, où pour chaque colonne, seul un échantillon sur e est lu, e étant un entier non nul.

6. Procédé de traitement selon la revendication précédente, dans lequel e=32.

7. Procédé de traitement selon l'une des revendications précédentes, comprenant en outre 2p phases de calcul respectivement effectuées par au moins 2p sous-moyens de calcul, suite à chaque phase de lecture de données au sein des mémoires, chaque phase de calcul étant opérée sur les données issues de la phase de lecture, de façon que la phase de calcul soit effectuée en temps réel.

8. Procédé de traitement selon la revendication précédente, dans lequel les 2p phases de calcul sont effectuées alternativement par 2p sous-moyens de calcul et 2p autres sous-moyens de calcul, de façon que la phase de calcul soit effectuée en temps réel.

9. Récepteur (REC) de type très large-bande mettant en oeuvre le procédé selon l'une quelconque des revendications précédentes couplé à un moyen de calcul, ledit récepteur comprenant une antenne de réception apte à recevoir des signaux RF/hyperfréquence analogiques, destinés à être traiter par ledit récepteur (REC), **caractérisé par le fait que** le récepteur comprend :
- 2n modules de réception couplés en parallèle entre l'antenne et le moyen de calcul, n étant un entier supérieur ou égal à un, chaque module comprenant 2p moyens de conversion analogique/numérique (ADC1, ..., ADC4) aptes à convertir les signaux RF/hyperfréquence analogiques en échantillons de données numériques en fonction d'une fréquence d'échantillonnage choisie selon le théorème de Shannon sur l'échantillonnage, p étant un entier supérieur ou égal à un, 2p codeurs de type haut-débit montés en parallèle, respectivement couplés au 2p convertisseurs analogiques/numériques, chaque codeur incorporant une mémoire, les 2p mémoires étant aptes à stocker les même échantillons de données, et
- un moyen de distribution (MDIST) apte à distribuer le signal électromagnétique vers chaque convertisseur analogique/numérique de chaque module.

10. Récepteur selon la revendication précédente, dans lequel le moyen de calcul incorpore 2p sous-moyens de calcul (SCAL1,..., SCAL8), chaque codeur étant couplé en sortie respectivement à l'un des sous-moyens.

11. Récepteur selon la revendication 9, dans lequel le moyen de calcul incorpore 4p sous-moyens de calcul, chaque codeur étant couplé en sortie à respectivement deux sous-moyens de calcul, en parallèle.

## Patentansprüche

1. Verfahren zum Verarbeiten von elektromagnetischen Signalen des Ultrabreitbandtyps, die von einem Empfänger (REC) bestehend aus parallelgeschalteten 2n Modulen (MOD1, MOD2) empfangen werden, wobei n eine ganze Zahl ungleich null ist, wobei jedes Modul 2p Codierer (COD1, ..., COD4) des Hochgeschwindigkeitstyps umfasst, wobei p eine ganze Zahl ungleich null ist, wobei jeder der Codierer einen Speicher (MEM1, ..., MEM4) beinhaltet,
**dadurch gekennzeichnet, dass** das Verfahren für jedes Modul Folgendes beinhaltet:
- Abtasten von analogen RF/Mikrowellensignalen, die in Abhängigkeit von einer Abtastfrequenz empfangen werden, ausgewählt gemäß dem Shannon-Abtasttheorem, um Samples von digitalen Daten zu erhalten, die für die analogen RF/Mikrowellensignale repräsentativ sind;
- 2p simultane Schreibphasen (Schreiben) derselben Samples von digitalen Daten auf die Speicher der darin enthaltenen 2p Codierer; dann
- 2p simultane Lesephasen (Lesen) dieser Daten-Samples,
so dass, sobald sich ein Modul in der Lesephase befindet, ein anderes Modul sich parallel in der Schreibphase befindet.

2. Verarbeitungsverfahren nach dem vorherigen Anspruch, wobei für jedes Modul (MOD1, MOD2) eine Lesephase des Speichers des i^{ten} Codierers das Lesen von k und k+2p-1 umfasst, wobei k = 1, 2, 3 oder 4, Samples von in dem Speicher gespeicherten digitalen Daten beinhaltet, wobei i eine ganze Zahl zwischen 1 und 2p ist.

3. Verarbeitungsverfahren nach dem vorherigen Anspruch, wobei jeder Speicher gemäß einer in Reihen und Spalten strukturierten Matrix organisiert ist und wobei jede Lesephase eines Speichers entlang den Spalten erfolgt und wobei nur die Samples von Daten von einer von d Spalten gelesen werden, wobei d eine ganze Zahl ungleich null ist.

4. Verarbeitungsverfahren nach dem vorherigen Anspruch, wobei d = 128 ist.

5. Verarbeitungsverfahren nach Anspruch 2, wobei jeder Speicher gemäß einer in Reihen und in Spalten strukturierten Matrix organisiert ist und wobei jede Lesephase eines Speichers entlang den Spalten erfolgt, wobei für jede Spalte nur eins von e Samples gelesen wird, wobei e eine ganze Zahl ungleich null ist.

6. Verarbeitungsverfahren nach dem vorherigen Anspruch, wobei e = 32 ist.

7. Verarbeitungsverfahren nach einem der vorherigen Ansprüche, das ferner 2p Rechenphasen beinhaltet, die jeweils durch wenigstens 2p Rechensubmittel nach jeder Datenlesephase in den Speichern ausgeführt werden, wobei jede Rechenphase auf die aus der Lesephase kommenden Daten angewandt wird, so dass die Rechenphase in Echtzeit erfolgt.

8. Verarbeitungsverfahren nach dem vorherigen Anspruch, wobei die 2p Rechenphasen abwechselnd durch 2p Rechensubmittel und 2p andere Rechensubmittel durchgeführt werden, so dass die Rechenphase in Echtzeit erfolgt.

9. Empfänger (REC) des Ultrabreitbandtyps, der das Verfahren nach einem der vorherigen Ansprüche ausführt, gekoppelt mit einem Rechenmittel, wobei der Empfänger eine Empfangsantenne umfasst, die analoge RF/Mikrowellensignale empfangen kann, die vom Empfänger (REC) verarbeitet werden sollen, **dadurch gekennzeichnet, dass** der Empfänger Folgendes umfasst:
- 2n Empfangsmodule, die zwischen der Antenne und den Rechenmitteln parallelgeschaltet sind, wobei n eine ganze Zahl gleich oder größer als eins ist, wobei jedes Modul 2p Analog/Digital-Umwandlungsmittel (ADC1, ..., ADC4) umfasst, die die analogen RF/Mikrowellensignale in Samples von digitalen Daten in Abhängigkeit von einer Abtastfrequenzauswahl gemäß dem Shannon-Abtasttheorem umwandeln können, wobei p eine ganze Zahl gleich oder größer als eins ist, 2p parallelgeschaltete Hochgeschwindigkeitscodierer, jeweils mit den 2p Analog/Digital-Wandlern gekoppelt, wobei jeder Codierer einen Speicher beinhaltet, wobei die 2p Speicher dieselben Daten-Samples speichern können, und
- ein Verteilungsmittel (MDIST), das das elektromagnetische Signal zu jedem Analog/Digital-Wandler jedes Moduls verteilen kann.

10. Empfänger nach dem vorherigen Anspruch, wobei das Rechenmittel 2p Rechensubmittel (SCAL1,..., SCAL8) beinhaltet, wobei jeder Codierer jeweils am Ausgang mit einem der Submittel gekoppelt ist.

11. Empfänger nach Anspruch 9, wobei das Rechenmittel 4p Rechensubmittel beinhaltet, wobei jeder Codierer am Ausgang mit jeweils zwei Rechensubmitteln parallelgeschaltet ist.

## Claims

1. A method for processing electromagnetic signals of the ultra-wideband type that are received by a receiver (REC) made up of 2n modules (MOD1, MOD2) coupled in parallel, with n being a non-zero integer, each module comprising 2p encoders (COD1, ..., COD4) of the high speed type, with p being a non-zero integer, each of said encoders incorporating a memory (MEM1, ..., MEM4),
**characterised in that** for each module said method comprises:
- sampling analogue RF/microwave signals received as a function of a sampling frequency selected according to the Shannon sampling theorem, so as to obtain samples of digital data that represent said analogue RF/microwave signals;
- 2p simultaneous write phases (writing) of the same samples of digital data on the memories of the 2p encoders that it incorporates; then
- 2p simultaneous read phases (reading) of said samples of data,
so that as soon as a module is in the read phase, another module is in the write phase at the same time.

2. The processing method according to the preceding claim, wherein, for each module (MOD1, MOD2), a phase of reading the memory of the i^{-th} encoder comprises reading the k and k+2p-1, with k = 1, 2, 3 or 4, samples of digital data stored by said memory, with i being an integer varying between 1 and 2p.

3. The processing method according to the preceding claim, wherein each memory is organised according to a matrix that is structured in rows and columns and wherein each phase of reading a memory is carried out along the columns and where only the samples of data of one column in d are read, with d being a non-zero integer.

4. The processing method according to the preceding claim, wherein d = 128.

5. The processing method according to claim 2, wherein each memory is organised according to a matrix that is structured in rows and in columns and wherein each phase of reading a memory is carried out along the columns, where for each column only one sample in e is read, with e being a non-zero integer.

6. The processing method according to the preceding claim, wherein e = 32.

7. The processing method according to any one of the preceding claims, further comprising 2p computation phases, which are respectively carried out by at least 2p computation sub-means, following each phase of reading data within the memories, each computation phase being applied to the data coming from the reading phase, so that the computation phase is carried out in real time.

8. The processing method according to the preceding claim, wherein the 2p computation phases are alternately carried out by 2p computation sub-means and 2p other computation sub-means, so that the computation phase is carried out in real time.

9. A receiver (REC) of the ultra-wideband type implementing the method according to any one of the preceding claims, coupled to a computation means, said receiver comprising a reception antenna capable of receiving analogue RF/microwave signals intended to be processed by said receiver (REC), **characterised in that** said receiver comprises:
- 2n reception modules coupled in parallel between said antenna and said computation means, with n being an integer greater than or equal to one, each module comprising 2p analogue/digital conversion means (ADC1, ..., ADC4) capable of converting said analogue RF/microwave signals into samples of digital data as a function of a sampling frequency selected according to the Shannon sampling theorem, with p being an integer greater than or equal to one, 2p high speed-type encoders mounted in parallel, respectively coupled to the 2p analogue/digital converters, each encoder incorporating a memory, the 2p memories being able to store the same data samples, and
- a distribution means (MDIST) capable of distributing the electromagnetic signal to each analogue/digital converter of each module.

10. The receiver according to the preceding claim, wherein said computation means incorporates 2p computation sub-means (SCAL1,..., SCAL8), each encoder being respectively coupled at the output to one of said sub-means.

11. The receiver according to claim 9, wherein said computation means incorporate 4p computation sub-means, each encoder being coupled in parallel at the output to two parallel computation sub-means, respectively.
